# EUROPEAN PATENT APPLICATION

(11) **EP 4 597 144 A1**
(43) Date of publication of application: **06.08.2025**
(21) Application number: 24155669.5
(22) Date of filing: 05.02.2024
(51) Int. Cl.: G01R 33/3815

(54) **AUTONOMUOUSLY POWERED MRI MAGNET CONTROLS**

(71) Applicant: Koninklijke Philips N.V., 5656 AG Eindhoven (NL)
(72) Inventor: FORTHMANN, Peter, Eindhoven (NL); LIPS, Oliver, Eindhoven (NL); VERNICKEL, Peter, 5656AG Eindhoven (NL)
(74) Representative: Philips Intellectual Property & Standards

(57) **Abstract**

The invention relates to a magnetic resonance imaging magnet assembly (1), comprising:
a magnetic resonance imaging magnet (2),
a ramp down circuit (3) for monitoring and/or controlling a ramp down event of the magnetic resonance imaging magnet (2), and
a monitoring circuit (4) which is configured for
a) monitoring power supplied from a power supply (6) to the magnetic resonance imaging magnet (2),
b) in case of a failure of the power supplied to the magnetic resonance imaging magnet (2) and a resulting discharge of the magnetic resonance imaging magnet (2), generating a voltage by making a current through the magnetic resonance imaging magnet (2) flow through a dumping device (5), and
c) powering the ramp down circuit (3) by the generated voltage.

In this way, a robust and efficient system for operating HTS magnets, especially in the context of MRI systems and similar applications is provided.

## Description

### FIELD OF THE INVENTION

The invention relates to a magnetic resonance imaging magnet assembly, comprising a magnetic resonance imaging magnet and a ramp down circuit for monitoring and/or controlling a ramp down event of the magnetic resonance imaging magnet, and to a method for operating such an assembly.

### BACKGROUND OF THE INVENTION

The field of superconducting magnets, particularly MgB2 (magnesium diboride) high-temperature superconducting (HTS) magnets, has been of high interest in recent years. These magnets are essential in various applications, notably in medical imaging devices like MRI (magnetic resonance imaging) systems. However, an issue in the operation of these magnets is the formation of persistent joints.

A solution to this challenge involves the use of driven-mode powering by a permanently connected power supply. This method offers a dual advantage. First, it allows for an alternative to persistent operation, effectively addressing the issue of persistent joints. Secondly, it enables rapid powering up and down of the magnet system. This rapid transition is feasible due to the elimination of cooldown time typically required for persistent current switches. Moreover, during the ramp-down phase, the circuitry responsible for monitoring and controlling this process must remain powered, highlighting the need for a reliable and continuous power supply.

Such systems are not without their challenges. A critical problem arises when there is a failure in the supply cable, leading to the power supply's inability to maintain the required current. Initiating a controlled ramp-down becomes imperative in such scenarios. While a passive solution to this failure mode is possible, often, more sophisticated circuitry would be desired for effectively controlling the ramping procedure, such as managing the dump resistor, or for monitoring purposes.

Another issue occurs during power faults, such as power outages, mechanical cable breakage, or accidental disconnects. In these situations, an alternative power source is necessary to keep the control circuitry operational. Conventionally, this could be achieved using a battery. However, the need for regular maintenance and the requirement of a large battery pack to operate bigger components, such as relays and contactors, make this a less viable solution.

In MRI systems, the concept of "driven mode" describes a specific method of operating superconducting magnets, which are crucial components of these systems. Understanding driven mode requires a basic knowledge of MRI and the role played by superconducting magnets. MRI is a medical imaging technique that visualizes detailed internal structures using a strong magnetic field, radio waves, and a computer, producing images of the body's organs and tissues. At the heart of an MRI machine lies a superconducting magnet that generates a highly uniform and stable magnetic field, vital for aligning hydrogen protons in the body, subsequently manipulated by radiofrequency pulses to create the imaging signal.

Superconducting magnets in MRI systems can function in two principal modes: persistent and driven. In persistent mode, the magnet, once energized to its operating current, can sustain its magnetic field without additional energy, thanks to the superconducting state of the wire, which exhibits no electrical resistance. This mode involves a superconducting switch, termed a "persistent (current) switch," which is heated to transition it to a resistive state and then, after charging, cooled back to a superconducting state, thereby "locking" the current in the circuit and maintaining the magnetic field independently of a power supply. This mode also involves persistent joints everywhere that exhibit no losses and can therefore also sustain the current.

In contrast, driven mode involves the continuous connection of the superconducting magnet to an external power supply, i.e. a continuous injection of current, as opposed to current being locked in a persistent current loop. This allows for dynamic control over the magnetic field, with the power supply actively maintaining the current in the superconducting coils. The driven mode offers significant advantages in scenarios requiring quick changes in the magnetic field, such as certain advanced MRI techniques or research applications.

The driven mode has its own set of advantages and challenges. Its flexibility permits dynamic adjustment of the magnetic field strength, and it facilitates rapid transitions between different magnetic field strengths without the need for the cooldown and warm-up periods associated with switching in and out of persistent mode. However, this mode also presents challenges, including the need for a reliable, stable, and uninterrupted power supply, as any failure can rapidly diminish the magnetic field. Additionally, it requires complex control systems to continuously monitor and adjust the magnetic field.

In the realm of MRI, driven mode is particularly beneficial for advanced imaging techniques that necessitate dynamic changes in the magnetic field. Nevertheless, it introduces complexities in terms of power supply management and control systems. These systems must be robust and fail-safe to ensure consistent imaging quality, patient safety and safety in general, addressing the need for precision in medical diagnostics.

Existing literature discusses a magnetic resonance imaging device that operates without liquid helium and uses a superconducting magnet in driven mode: In order to provide a magnetic resonance imaging device that does not use liquid helium and that can stably operate a superconducting magnet operating in driven mode, according to WO2014/199793 A1, at a power source unit that supplies current to a superconducting coil, provided with a control unit that controls the current supplied to the superconducting coil on the basis of at least one unit of information among the power supply state from the outside to the power source unit, the operating state of a refrigerator, the temperature of the superconducting coil, the magnetostatic field strength, the current value flowing to the superconducting coil, and the nuclear magnetic resonance signal detected by a detector.

### SUMMARY OF THE INVENTION

Therefore, it is the object of the invention to provide a robust and efficient system for operating HTS magnets, especially in the context of MRI systems and similar applications. This system aims to overcome the challenges associated with persistent joints and the need for rapid transition between powering states while ensuring reliability during power supply failures.

According to the invention, this object is addressed by the subject matter of the independent claims. Preferred embodiments of the invention are described in the sub claims.

Therefore, according to the invention, a magnetic resonance imaging magnet assembly, comprising:
a magnetic resonance imaging magnet,
a ramp down circuit for monitoring and/or controlling a ramp down event of the magnetic resonance imaging (MRI) magnet, and
a monitoring circuit which is configured for
   a) monitoring power supplied from a power supply to the magnetic resonance imaging magnet,
   b) in case of a failure of the power supplied to the magnetic resonance imaging magnet and a resulting discharge of the magnetic resonance imaging magnet, generating a voltage by making a current through the magnetic resonance imaging magnet flow through a dumping device, and
   c) powering the ramp down circuit by the generated voltage.

According to the invention, an innovative approach is proposed, where the energy from the magnet itself is utilized to power this circuitry, leveraging the current released from the magnet. By leveraging advanced control and monitoring circuitry and using the magnet's inherent energy, especially during power outages, this invention aims to enhance the operational efficiency and reliability of superconducting magnets, thereby contributing significantly to their practical application in medical and scientific fields. If the power supply for the MRI magnet or any of the cable connections fail, i. e. its own connection to the power supply or the magnet's cable connections, the monitoring circuit detects this. While, in general, the ramp down circuit and the monitoring circuit may be separate from each other, according to an embodiment of the invention, the ramp down circuit and the monitoring circuit are integrated into each other, i. e. comprised in one single device.

Generating a voltage by making a current through the magnetic resonance imaging magnet flow through a dumping device may be achieved with different techniques. However, according to an embodiment of the invention, the dumping device comprises a resistor and/or a diode bank.

Further, according to an embodiment of the invention, the ramp down circuit is configured for controlling switches that switch elements in the dumping device in order to control power dissipation. Switches can encompass contactors or solid-state relays, and the manipulation of these switches may be contingent upon the advancement of the discharge.

According to an embodiment of the invention, the ramp down circuit is configured for monitoring magnet sensors and the progress of the discharge at the same time. The fact that the ramp-down circuit is designed to concurrently monitor both magnet sensors and the discharge progression provides for enhanced functionality by facilitating simultaneous monitoring, thereby improving the efficiency and accuracy of the magnet assembly's performance during the discharge process. Further, in this respect, according to an embodiment of the invention, a transmitter is provided which is configured for transmitting data output by ramp down circuit to an external host, for example via ethernet. This can be important for safe operation and diagnosis.

While, in general, the invention may be used for different types of magnets, according to an embodiment of the invention, the magnetic resonance imaging magnet is a high-temperature superconducting magnet.

The invention is further related to a method for operating a magnetic resonance imaging magnet assembly,
the assembly comprising a magnetic resonance imaging magnet and a ramp down circuit for monitoring and/or controlling a ramp down event of the magnetic resonance imaging magnet,
the method comprising the following method steps:
   monitoring power supplied to the magnetic resonance imaging magnet,
   in case of a failure of the power supplied to the magnetic resonance imaging magnet and a resulting discharge of the magnetic resonance imaging magnet, generating a voltage by making a current through the magnetic resonance imaging magnet flow through a dumping device, and
   powering the ramp down circuit by the generated voltage.

Preferably, the dumping device uses a resistor and/or a diode bank. Further, according to an embodiment of the invention, the ramp down controls switches that switch elements in the dumping device in order to control power dissipation. Furthermore, it is preferred that the ramp down circuit monitors magnet sensors and the progress of the discharge at the same time. Data output by the ramp down circuit may be transmitted to an external host.

The invention also relates to a computer program for a magnetic resonance imaging magnet assembly as described further above, comprising instructions which, when the program is executed by a computer, cause the computer to perform a method as described before.

Finally, the invention also relates to a magnetic resonance imaging system with a magnetic resonance imaging magnet assembly as described further above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a magnetic resonance imaging system according to an embodiment of the invention, and
Fig. 2 depicts schematically depicts a method according to an embodiment of the invention.

### DETAILED DESCRIPTION OF EMBODIMENTS

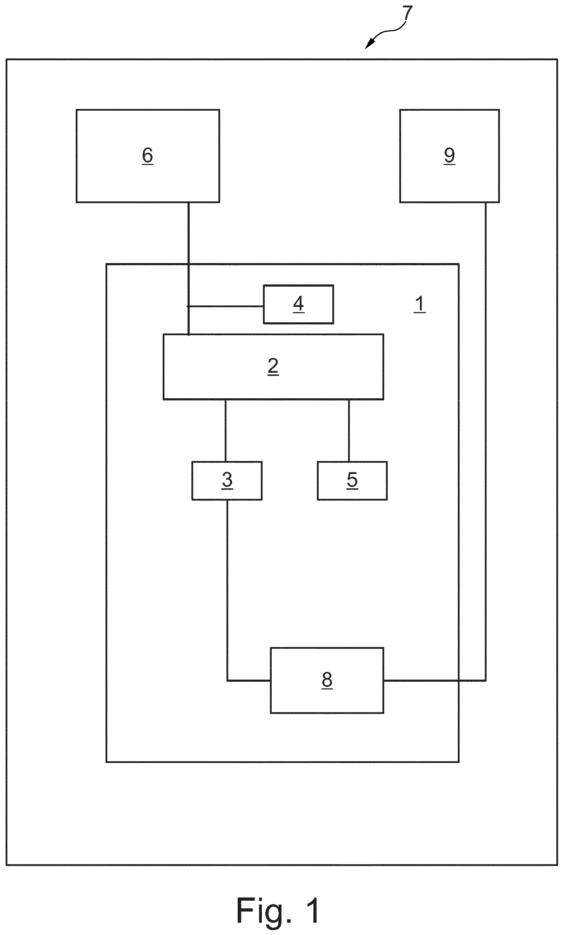

A magnetic resonance imaging magnet assembly 1 according to an embodiment of the invention is schematically depicted in Fig. 1. This magnetic resonance imaging magnet assembly 1 comprises a magnetic resonance imaging magnet 2 which is a high-temperature superconducting magnet made from MgB2 (magnesium diboride), a ramp down circuit 3 with a resistor and/or a diode bank for
a) monitoring and/or controlling a ramp down event of the magnetic resonance imaging magnet 2, and a monitoring circuit 4 which is configured for a monitoring power supplied from a power supply 6 to the magnetic resonance imaging magnet 2,
b) in case of a failure of the power supplied to the magnetic resonance imaging magnet 2 and a resulting discharge of the magnetic resonance imaging magnet 2, generating a voltage by making a current through the magnetic resonance imaging magnet 2 flow through a dumping device 5, and
c) powering the ramp down circuit 3 by the generated voltage.
The ramp down circuit 3 is further configured for controlling switches that switch elements 7 in the dumping device 5 in order to control power dissipation and for monitoring magnet sensors and the progress of the discharge at the same time. In addition, a transmitter 8 is provided which is configured for transmitting data output by ramp down circuit 3 to a host 9. In this way, the ramp-down circuit's design allows it to simultaneously monitor both the magnet sensors and the discharge progression. This concurrent monitoring capability enhances functionality, leading to improved efficiency and accuracy in the performance of the magnet assembly 1 during a discharge process.

Therefore, according to the present invention, an innovative solution is proposed where the energy stored in the magnet 2 itself is utilized to power a control and monitoring circuitry during power outages or faults. By leveraging advanced control and monitoring circuitry and harnessing
the inherent energy of the magnet 2, particularly during power failures, this invention aims to enhance the efficiency and reliability of superconducting magnets in medical and scientific applications. In case of a power supply failure or any cable connection failure, the monitoring circuit detects the issue immediately. This allows for quick action to be taken to prevent any adverse effects on the magnet's operation. By leveraging the energy stored in the magnet 2, this invention provides a more efficient and reliable solution for superconducting magnets in various applications.

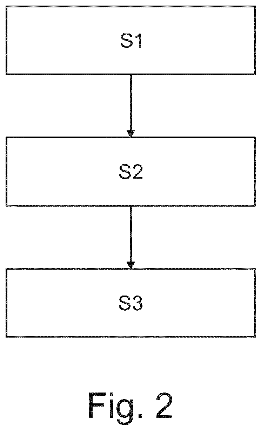

With this magnetic resonance imaging magnet assembly 1 from Fig. 1 the following method which is depicted in Fig. 2 becomes possible.

In a first step S1, power supplied to the magnetic resonance imaging magnet 2 is monitored.

In a second step S2, in case of a failure of the power supplied to the magnetic resonance imaging magnet 2 and a resulting discharge of the magnetic resonance imaging magnet 2, a voltage is generated by making a current through the magnetic resonance imaging magnet 2 flow through a dumping device 5.

In a third step S3, the ramp down circuit 3 is powered by the generated voltage.

As already mentioned further above, the ramp down circuit 3 controls switches that switch elements 7 in the dumping device 5 in order to control power dissipation and monitors magnet sensors and the progress of the discharge at the same time. Data output by ramp down circuit 3 is transmitted to a host 9.

Therefore, the invention ensures a new functionality and reliability, which may be particularly helpful in the demanding realms of medical applications.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| magnetic resonance imaging magnet assembly | 1 |
| magnetic resonance imaging magnet | 2 |
| ramp down circuit | 3 |
| monitoring circuit | 4 |
| dumping device | 5 |
| power supply | 6 |
| magnetic resonance imaging system | 7 |
| transmitter | 8 |
| host | 9 |

## Claims

1. Magnetic resonance imaging magnet assembly (1), comprising:
a magnetic resonance imaging magnet (2),
a ramp down circuit (3) for monitoring and/or controlling a ramp down event of the magnetic resonance imaging magnet (2), and
a monitoring circuit (4) which is configured for
a) monitoring power supplied from a power supply (6) to the magnetic resonance imaging magnet (2),
b) in case of a failure of the power supplied to the magnetic resonance imaging magnet (2) and a resulting discharge of the magnetic resonance imaging magnet (2), generating a voltage by making a current through the magnetic resonance imaging magnet (2) flow through a dumping device (5), and
c) powering the ramp down circuit (3) by the generated voltage.

2. Magnetic resonance imaging magnet assembly (1) according to claim 1, wherein the dumping device (5) comprises a resistor and/or a diode bank.

3. Magnetic resonance imaging magnet assembly (1) according to any one of claims 1 and 2, wherein the ramp down circuit (3) is configured for controlling switches that switch elements (7) in the dumping device (5) in order to control power dissipation.

4. Magnetic resonance imaging magnet assembly (1) according to any one of claims 1 to 3, wherein the ramp down circuit (3) is configured for monitoring magnet sensors and the progress of the discharge at the same time.

5. Magnetic resonance imaging magnet assembly (1) according to any one of claims 1 to 4, further comprising a transmitter (8) which is configured for transmitting data output by ramp down circuit (3) to a host (9).

6. Magnetic resonance imaging magnet assembly (1) according to any one of claims 1 to 5, wherein the magnetic resonance imaging magnet (2) is a high-temperature superconducting magnet.

7. Method for operating a magnetic resonance imaging magnet assembly (1),
the assembly comprising a magnetic resonance imaging magnet (2) and a ramp down circuit (3) for monitoring and/or controlling a ramp down event of the magnetic resonance imaging magnet (2), the method comprising the following method steps:
monitoring power supplied to the magnetic resonance imaging magnet (2),
in case of a failure of the power supplied to the magnetic resonance imaging magnet (2) and a resulting discharge of the magnetic resonance imaging magnet (2), generating a voltage by making a current through the magnetic resonance imaging magnet (2) flow through a dumping device (5), and
powering the ramp down circuit (3) by the generated voltage.

8. Method according to claim 7, wherein the dumping device (5) uses a resistor and/or a diode bank.

9. Method according to any one of claims 7 and 8, wherein the ramp down circuit (3) controls switches that switch elements (7) in the dumping device (5) in order to control power dissipation.

10. Method according to any one of claims 7 to 9, wherein the ramp down circuit (3) monitors magnet sensors and the progress of the discharge at the same time.

11. Method according to any one of claims 7 to 10, data output by ramp down circuit (3) is transmitted to a host (9).

12. Computer program for a magnetic resonance imaging magnet assembly (1) according to any one of claims 1 to 6, comprising instructions which, when the program is executed by a computer, cause the computer to perform a method according to any one of claims 7 to 11.

13. Magnetic resonance imaging system (7) with a magnetic resonance imaging magnet assembly (1) according to any one of claims 1 to 6.
